# FASCICULE DE BREVET EUROPEEN

(11) **EP 0 913 938 B1**
(45) Date de publication et mention de la délivrance du brevet: **02.01.2004**
(21) Numéro de dépôt: 98402675.7
(22) Date de dépôt: 27.10.1998
(51) Int. Cl.: H03K 17/18, F15B 15/28

(54) **Interrupteur statique de fin de course pour commande de disjoncteur**
Statischer Endschalter zur Betätigung eines Leistungsschalters
Static limit switch for operating a circuit breaker

(30) Priorité: 03.11.1997 FR 9713768
(43) Date de publication de la demande: 06.05.1999
(73) Titulaire: Alstom T & D SA, 75116 Paris (FR)
(72) Inventeur: Ebersohl, Gérard, 69350 La Mulatière (FR)
(74) Mandataire: de Lambilly Delorme, Marie Pierre

(56) Documents cités:
- EP-A- 0 574 300
- EP-A- 0 609 158
- EP-A- 0 797 010
- DE-A- 2 407 989

## Description

L'invention concerne les disjoncteurs haute et moyenne tension et plus particulièrement une commande basse tension pour ouvrir ou fermer de tels disjoncteurs.

L'ouverture ou déclenchement et la fermeture ou enclenchement de ce genre de disjoncteurs se fait par l'intermédiaire de deux bobines de commande qui agissent sur des électrovannes par exemple s'il s'agit d'un disjoncteur à commande hydraulique pour déplacer les éléments mobiles du disjoncteur (contacts de puissance en particulier).

Le document EP-A-0 609 158 divulgue un exemple d'un tel circuits de commande.

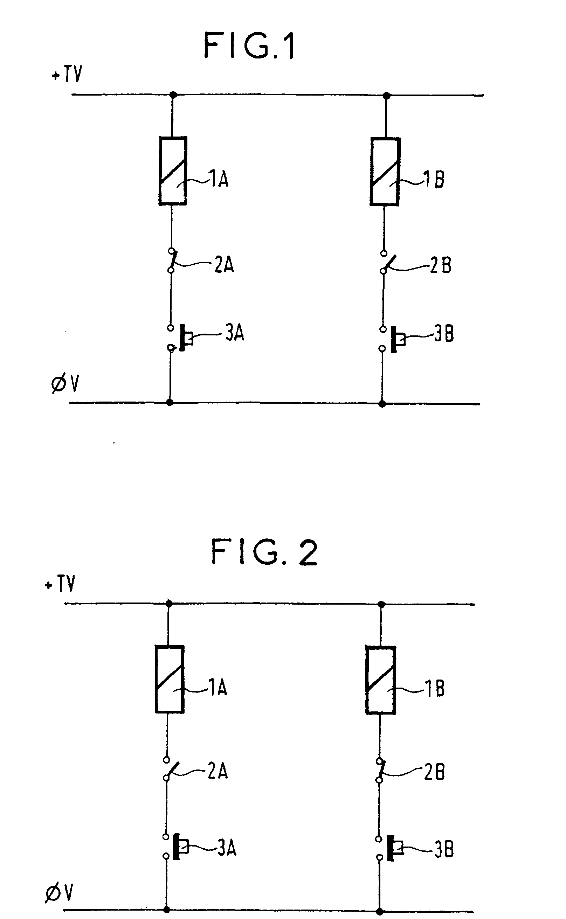

La figure 1 illustre très schématique une telle commande. Comme visible sur cette figure, elle comprend deux bobines de commande, une 1A pour ouvrir le disjoncteur lorsqu'elle est alimentée, l'autre 1B pour fermer le disjoncteur lorsqu'elle est alimentée, montées chacune en série avec un interrupteur de fin de course 2A,2B et un bouton poussoir de commande locale 3A,3B. Chaque interrupteur 2A,2B est lié au mouvement mécanique du disjoncteur. En position de fermeture du disjoncteur, l'un des interrupteurs comme 2A est fermé et l'autre 2B est ouvert. Si on appuie sur le bouton 3A, la bobine 1A est excitée puisque l'interrupteur 2A est fermé, ce qui commande par exemple une électrovanne et le disjoncteur se met en mouvement - un pôle du disjoncteur se déplace dans sa position d'ouverture. Puis l'interrupteur 2A s'ouvre en fin de course du pôle en question ce qui coupe l'alimentation de la bobine 1A. Simultanément, l'interrupteur 2B se ferme. Le disjoncteur est maintenant ouvert. La figure 2 illustre très schématiquement la commande dans la position d'ouverture du disjoncteur. Pour fermer le disjoncteur, on appuie sur le bouton 38 ce qui excite la bobine 1B. Le disjoncteur se met en mouvement et vient en position de fermeture. L'interrupteur 2B s'ouvre tandis que l'interrupteur 2A se ferme et on se retrouve avec la commande dans l'état montré sur la figure 1.

Les fins de course associées aux organes mobiles du disjoncteur sont très importantes. En particulier, on cherche à obtenir un déplacement très rapide des contacts de puissance du disjoncteur pour pouvoir gérer au mieux des situations de court-circuit dans un réseau électrique. Pour accélérer le mouvement de ces disjoncteurs, on sur-excite très fortement les bobines de commande. Mais en contre partie, on doit avoir un temps de sur-excitation des bobines de commande très court et on a donc besoin que les interrupteurs de fin de course de la commande liés au mouvement du disjoncteur changent d'état (ouvert ou fermé) très rapidement.

Par ailleurs, des études ont montrées que dans 25% des cas, les défaillances d'un disjoncteur sont dues à un défaut de fonctionnement des interrupteurs auxiliaires, en particulier des interrupteurs de fin de course. Bien souvent. le disjoncteur reste fermé pendant une durée relativement longue. Pendant ce temps, les interrupteurs de fin de course ont tendance à s'oxyder et à présenter de ce fait une résistance de contact anormalement élevée. Il s'ensuit un défaut de fonctionnement du disjoncteur en présence d'un court-circuit et des conséquences graves pour le tenue du réseau électrique dans lequel est monté ce disjoncteur.

Il a donc été envisagé d'utiliser comme interrupteur de fin de course dans la commande de tels disjoncteurs, des interrupteurs statiques à base de transistors, comme des transistors MOS par exemple, qui combinés avec des capteurs de position présentent l'avantage de pouvoir être testés de façon permanente.

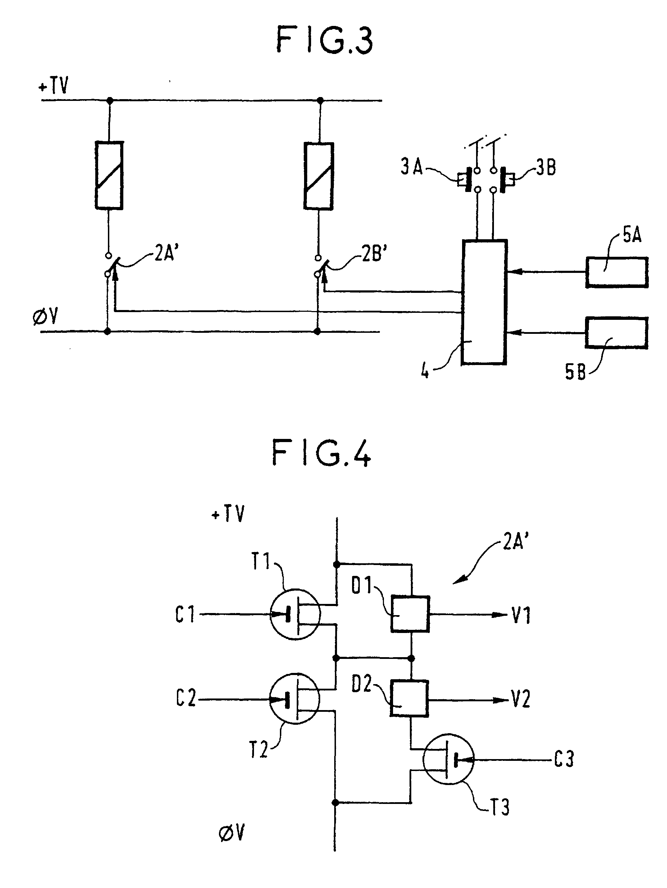

La figure 3 illustre un schéma d'une telle commande. Comme visible sur cette figure, chaque bobine de commande est reliée en série avec un interrupteur statique de fin de course 2A' et 2B'. Ces interrupteurs statiques sont commandés depuis un micro-contrôleur 4 qui reçoit des signaux représentatifs de la position du disjoncteur et produits par des capteurs de position 5A et 5B, du type capteurs magnétiques par exemple, ce qui permet de tester à tout moment l'état de fonctionnement des interrupteurs statiques, quelque soit la position du disjoncteur.

Le but de l'invention est de proposer un interrupteur statique de fin de course à haut niveau de disponibilité et complètement testable à tout moment quelque soit la position du disjoncteur.

Un autre but de l'invention est de proposer une commande de disjoncteur incluant un tel interrupteur protégé contre une mise en court-circuit d'une ou des deux bobines de commande.

A cet effet, l'invention a pour objet un interrupteur statique de fin de course pour une commande de disjoncteur, caractérisé en ce qu'il comprend deux transistors montés en série dans un circuit d'alimentation d'une bobine de commande du disjoncteur, et commandés sélectivement pour fermer ou ouvrir ce circuit d'alimentation, un moyen de détection monté en dérivation aux bornes des premier et second transistors pour détecter un état de conduction ou de non conduction de l'un et de l'autre desdits premier et second transistors aux fins de réaliser un test de leur bon fonctionnement et, un troisième transistor monté en série avec le moyen de détection en vue de réaliser un test de bon fonctionnement du moyen de détection.

L'invention s'étend à une commande de disjoncteur incluant un tel interrupteur statique de fin de course et un système de protection de l'interrupteur statique contre une mise en court circuit de la bobine de commande, ce système de protection comprenant une bobine de protection montée en série entre la bobine de commande et l'interrupteur, d'inductance bien plus faible que l'inductance de la bobine de commande, et un circuit monté aux bornes de la bobine de protection apte à détecter que le niveau de tension aux bornes de cette bobine de protection est supérieur à un seuil correspondant à la mise en court-circuit de la bobine de commande et à forcer l'ouverture d'un transistor de l'interrupteur pour le mettre dans un état de non conduction afin d'ouvrir le circuit d'alimentation de la bobine de commande.

Un exemple de réalisation de l'invention est décrit ci-après plus en détail et illustré sur les dessins.
La figure 1 illustre très schématiquement une commande de disjoncteur dans une position de fermeture.
La figure 2 illustre la commande de disjoncteur de la figure 1 en position d'ouverture du disjoncteur.
La figure 3 illustre une commande de disjoncteur avec des interrupteurs statiques de fin de course et un micro-contrôleur.
La figure 4 illustre un premier exemple de réalisation d'un interrupteur statique de fin de course selon l'invention.
La figure 5 illustre un second exemple de réalisation d'un interrupteur statique de fin de course selon l'invention.
La figure 6 illustre un troisième exemple de réalisation d'un interrupteur statique de fin de course selon l'invention.
La figure 7 illustre l'interrupteur statique de fin de course de la figure 4 avec un système de protection contre une mise en court-circuit d'une bobine de commande.

Figure 4, un interrupteur statique de fin de course pour une commande de disjoncteur, comme l'interrupteur 2A', mais à haut niveau de disponibilité et complètement testable, comprend deux transistors T1, T2 montés en série dans le circuit électrique d'alimentation d'une bobine de commande, dans le cas de l'exemple la bobine 1A, qui sur réception de signaux électriques respectifs C1 et C2 conduisent ou ne conduisent pas le courant dans ce circuit. L'interrupteur comprend aussi, dans l'exemple de réalisation de la figure 4, deux capteurs de tension D1,D2 montés respectivement en dérivation aux bornes des transistors T1 et T2 et qui fournissent respectivement des signaux de vérification V1 et V2 au micro-contrôleur 4 représentatifs de l'état fermé ou ouvert des transistors T1 et T2. Il faut comprendre que ces signaux de vérification V1 et V2 sont produits en réponse au signaux de commande C1 et C2 et servent à la mise en oeuvre d'une séquence d'auto-diagnostic de l'interrupteur par le micro-contrôleur 4 quand le disjoncteur se trouve en état de veille.

Selon l'invention, l'interrupteur statique de fin de course 2A' comprend un troisième transistor T3 monté en série avec les deux détecteurs D1 et D2 pour couper, quand il est ouvert l'alimentation de ces derniers.

En régime de fonctionnement normal de l'interrupteur 2A', les deux signaux C1 et C2 à un certain niveau de tension sont appliqués simultanément sur les transistors T1 et T2 pour les rendre conducteurs de sorte que la bobine de commande 1A est alimentée ou pour les rendre non conducteurs de sorte à couper l'alimentation de la bobine de commande 1A.

La structure de l'interrupteur statique de fin de course avec le transistor auxiliaire T3 et les détecteurs D1 et D2 permet en plus, comme cela apparaîtra par la suite, de réaliser une séquence de test permettant de garantir à 100% la disponibilité de l'interrupteur.

Le test est effectué par l'intermédiaire d'un programme exécuté par le micro-contrôleur 4. Ce test peut être déclenché périodiquement. Par convention pour la suite, C1+,C2+,C3+ symbolisent des signaux de commande qui forcent les transistors T1,T2,T3 respectivement à passer dans un état de conduction (position fermée) et C1-,C2-,C3- symbolisent des signaux de commande inactifs en réponse auxquels les transistors T1,T2,T3 respectivement restent dans l'état de non conduction (position ouverte). V1+,V2+ symbolisent des signaux de vérification V1 et V2 respectivement représentatifs d'une présence de tension aux bornes respectivement des transistors T1 et T2 et V1-,V2- symbolisent des signaux de vérification V1 et V2 respectivement représentatifs de l'absence de tension aux bornes respectivement des transistorsT1 et T2.

### Séquence de test

1 - Les transistors T1,T2,T3 reçoivent les signaux de commande C1-,C2-,C3-. Le micro-contrôleur 4 doit détecter la réception des signaux de vérification V1-,V2- puisque D1 et D2 ne sont pas alimentés.
2 - Le micro-contrôleur 4 applique ensuite le signal de commande C3+ au transistor T3 (les transistors T1 et T2 recevant toujours les signaux C1- et C2-respectivement) et doit détecter la réception des signaux de vérification V1+,V2+. A ce stade, le bon fonctionnement de la chaîne de détection D1 et D2 est contrôlée.
3 - Le micro-contrôleur 4 applique ensuite le signal C2+ au transistor T2 (le transistor T1 recevant toujours le signal C1- et le transistor T3 recevant toujours le signal C3+) et doit détecter la réception des signaux de vérification V1 + et V2-.
4 - Le micro-contrôleur 4 applique ensuite le signal C2- au transistor T2 (le transistor T1 recevant toujours le signal C1- et le transistor T3 recevant toujours le signal C3+) et doit détecter la réception des signaux de vérification V1+ et V2+.
5 - Le micro-contrôleur 4 applique ensuite le signal C1+ au transistor T1 (le transistor T2 recevant toujours le signal C2- et le transistor T3 recevant toujours le signal C3+) et doit détecter la réception des signaux de vérification V1- et V2+.
6 - Le micro-contrôleur 4 applique ensuite le C1- au transistor T1 (le transistor T2 recevant toujours le signal C2- et le transistor T3 recevant toujours le signal C3+) et doit détecter la réception des signaux de vérification V1+ et V2+.
7 - Le micro-contrôleur applique enfin le signal C3- au transistor T3 (le transistor T1 recevant toujours le signal C1- et le transistor T2 recevant toujours le signal C2-) et doit détecter la réception des signaux de vérification V1- et V2-.

A noter que quand les transistors T1 et T2 reçoivent des signaux de commande C1- et C2-, les détecteurs D1 et D2 sont soumis à la moitié de la tension +TV et produisent les signaux V1+ et V2+ respectivement. Quand le micro-contrôleur 4 envoie un signal de commande C1+ sur le transistor T1, celui-ci se sature, la tension à ses bornes disparaît et par conséquent le détecteur D1 est soumis à une tension nulle et produit le signal V1-. Le détecteur D2 est lui soumis à une tension +TV et produit le signal V2+. Par conséquent, dans cet agencement il est nécessaire que chaque détecteur D1 ou D2 encode le signal V1 ou V2 avec une même valeur logique quand il détecte la présence d'une tension +TV et quand il détecte la présence d'une tension +TV/2.

A noter aussi que le transistor auxiliaire T3 confère à l'interrupteur statique selon l'invention une testabilité de 100% puisque toute défaillance, soit d'un élément de la chaîne de commande C1,C2,C3, soit d'un élément de la chaîne de vérification D1,D2,T3, soit l'un des éléments de commutation du circuit principal 1A,T1,T2 peut être détectée par le micro-contrôleur 4.

Dans l'agencement de la figure 4, les détecteurs D1 et D2 sont avantageusement constitués par l'association d'une source de courant constant, mise en série avec un photocoupleur: cette disposition permet l'encodage correct des signaux V1 et V2 dans les plages de tension requises, d'une part, et d'autre part, permet de transmettre les informations codées au micro-contrôleur 4 par l'intermédiaire de fibres optiques, assurant ainsi un isolement galvanique de ces informations. La même disposition est avantageuse pour la transmission des commandes C1,C2 et C3.

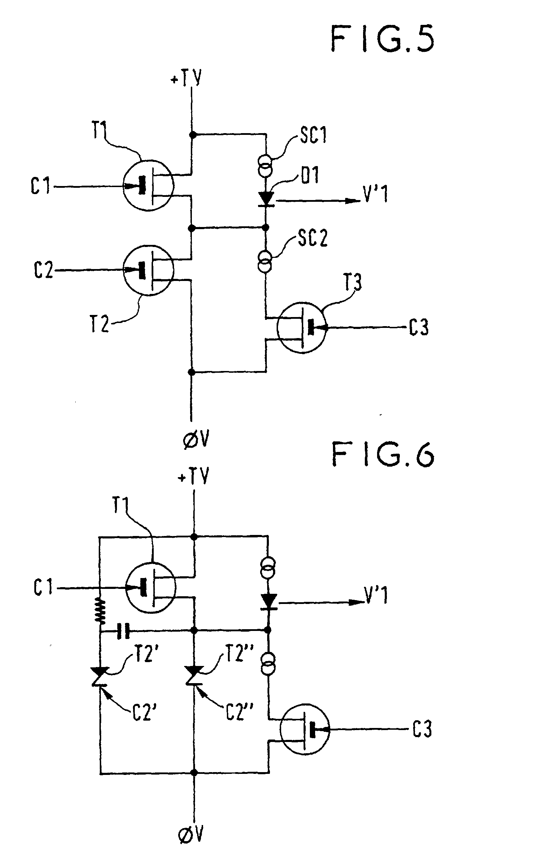

On a représenté sur la figure 5 un autre exemple de réalisation d'un interrupteur statique de fin de course selon l'invention dans lequel le détecteur D1 est précédé d'une source de courant SC1 montée en série avec le détecteur D1 aux bornes du transistor T1 et le second détecteur D2 est remplacé simplement par une source de courant SC2 ce qui permet, pour un même niveau de contrôle de la disponibilité de l'interrupteur, de n'utiliser qu'une seule prise d'information de vérification V1' produite par un photocoupleur D1. Par ailleurs, ce montage simplifie l'encodage logique du signal de vérification V1'. La séquence de test de la disponibilité de l'interrupteur statique devient la suivante :
1 - Les transistors T1,T2 et T3 recevant les signaux de commande C1-,C2-,C3- respectivement, le micro-contrôleur doit détecter la réception du signal de vérification V1'- indicatif d'une détection d'absence de tension.
2 - Le micro-controleur 4 applique ensuite le signal C3+ sur le transistor T3 et doit détecter la réception du signal de vérification V1'+ indicatif d'une détection de la présence d'une tension. A ce stade, on a vérifier que la chaîne de test est opérationnelle et que les transistors T1 et T2 sont dans un état de non conduction.
3 - Le micro-contrôleur applique ensuite le signal C3- sur le transistor T3 et doit détecter de nouveau la réception du signal de vérification V1'-.
4 - Le micro-contrôleur applique ensuite le signal C2+ sur le transistor T2 et doit détecter la réception du signal de vérification V1'+ si le transistor T2 est opérationnel en fermeture.
5 - Le micro-contrôleur applique ensuite le signal C2- sur le transistor T2 et doit détecter de nouveau la réception du signal de vérification V1'- si le transistor T2 est opérationnel en ouverture.
6 - Le micro-contrôleur applique ensuite le signal C3+ sur le transistor T3 et doit détecter la réception du signal de vérification V1'+.
7 - Le micro-contrôleur applique ensuite le signal C1+ sur le transistor T1 et doit détecter la réception du signal de vérification V1'- si le transistor T1 est opérationnel en fermeture.
8 - Le micro-contrôleur applique ensuite le signal C1- sur le transistor T1 et doit détecter la réception du signal de vérification V1+ si le transistor est opérationnel en ouverture.
9 - Le micro-contrôleur applique enfin le signal C3- sur le transistor T3 et doit détecter la réception du signal de vérification V1'-.

La figure 6 montre encore un autre exemple de réalisation de l'interrupteur statique selon l'invention dans lequel, par rapport à celui montré sur la figure 5, le transistor T2 est remplacé par une paire de thyristors T2' et T2" et d'un transistor MOS auxiliaire T1 commandés respectivement par des signaux de commande C2' et C2", l'un des thyristors étant utilisé pour l'ouverture et l'autre pour la fermeture du circuit d'alimentation de la bobine. Cet agencement permet de commuter de fortes puissances. La coupure du circuit d'alimentation de la bobine de commande s'effectue d'abord par l'intermédiaire des thyristors et ensuite par le transistor T1. Inversement, la fermeture du circuit d'alimentation de la bobine s'effectue d'abord par l'intermédiaire du transistor T1 puis par l'intermédiaire des thyristors. De cette manière, le transistor T1 s'ouvre et se ferme sans courant et permet le test périodique de l'interrupteur statique par une séquence voisine de celles décrites précédemment.

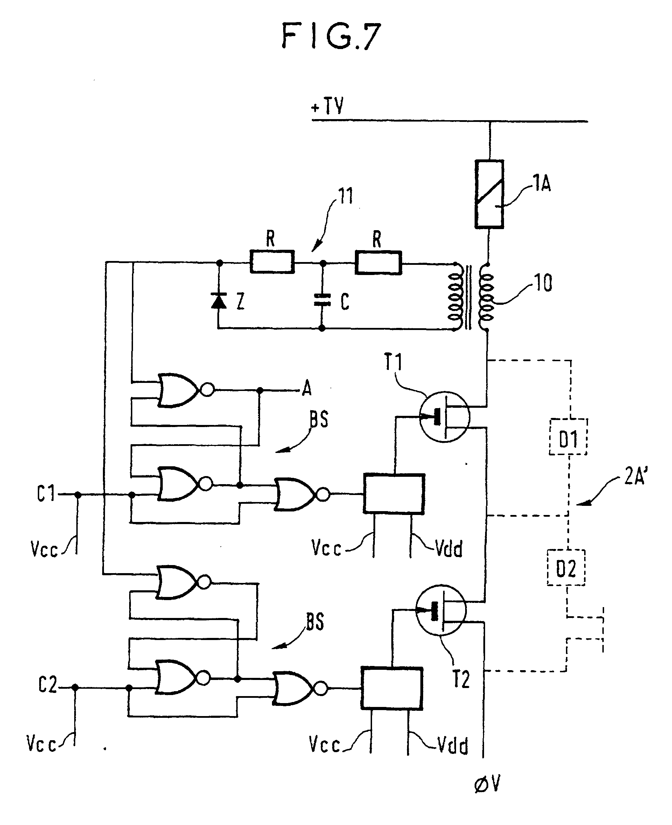

Sur la figure 7, on a représenté en partie une commande de disjoncteur avec un interrupteur statique 2A' selon l'invention monté en série dans le circuit d'alimentation de la bobine de commande 1A par exemple et qui est protégé contre un défaut de branchement en cours de maintenance du disjoncteur, le mettant directement sous la tension alimentant la bobine de commande 1A, c'est-à-dire quand la bobine de commande 1A est mise en court-circuit.

La bobine 1A est alimentée par exemple sous une tension +TV de 140 à 280 V et présente typiquement les caractéristiques suivantes : 0,1H et 100 Ω. Comme indiqué ci-dessus, un court-circuit de la bobine 1A sur l'interrupteur 2A' se traduit au moment du branchement de l'alimentation de la bobine 1A, par une brusque montée de la tension et du courant à leur valeur maximale dans les transistors T1 et T2 de l'interrupteur 2A'. Il est donc nécessaire de détecter l'arrivée de ce court-circuit et couper la ligne d'alimentation de l'interrupteur avant la destruction des transistors.

Un circuit de protection analogue doit être prévu pour l'interrupteur 2B'.

Par la suite, on décrit seulement le circuit de protection lié à l'interrupteur 2A'. Ce circuit de protection comprend d'abord une bobine de protection 10 montée en série entre la bobine de commande 1A et l'interrupteur statique 2A'. En cas de court-circuit, pendant un bref instant c'est la bobine 10 qui se voit appliquer toute la tension +TV à l'allumage de l'alimentation. De ce fait, il n'y aura pas ou peu de tension aux bornes des transistors T1 et T2. Le courant croit linéairement avec une pente di/dt importante (U=Ldi/dt, U=cte) mais le courant i conserve une valeur très modérée pendant les 10 premières microsecondes de l'établissement du court-circuit. Par ailleurs, lors de l'établissement de la tension +TV aux bornes de la bobine. le courant traversant la bobine de protection 10 croît linéairement avec une pente relativement faible, l'inductance de la bobine 1A étant très supérieure à celle de la bobine 10 dont l'inductance vaut typiquement 0,6mH. On notera par contre qu'en l'absence de court-circuit, la tension +TV est appliquée à la bobine 1A et le courant s'établit avec une pente considérablement plus faible que précédemment. De ce fait la tension aux bornes de la bobine 1A est extrêmement faible.

La bobine de protection 10, est réalisée à l'aide d'un noyau de ferrite par exemple qui présente l'avantage de posséder une perméabilité magnétique relative très stable pet élevée pour les faibles champs coercitifs, cette perméabilité relative passant brusquement à 1 à la saturation. La bobine de protection doit être dimensionnée pour ne pas saturer pour le courant à couper par l'interrupteur. Elle limite donc le courant dans l'interrupteur, à une valeur faible dans les premières micro-secondes succédant à l'établissement du court-circuit.

La détection d'une mise en court-circuit de la bobine de commande 1A est faite par une électronique 11 montée aux bornes de la bobine de protection 10. Cette électronique inclut comme visible sur la figure 7 un circuit RC ayant typiquement une constante de temps d'environ 10 µs. Ce circuit RC filtre les signaux hautes fréquence générés lors des commutations par les capacités parasites des bobines. Le signal produit par le circuit RC est écrêté par une diode Zener Z pour produire un signal logique qui attaque une bascule bi-stable BS mémorisant les états successifs de la bobine de commande 1A. Avantageusement, l'électronique 11 est isolé galvaniquement de la bobine de protection 10 si celle-ci constitue le primaire d'un transformateur, le secondaire étant constitué d'un enroulement de quelques spires pour ramener la tension à mesurer par l'électronique à quelques volts au moment du court-circuit.

Comme visible sur la figure 7, une bascule bi-stable BS est interposée entre la commande C1 et le transistor T1 et entre la commande C2 et le transistor T2 pour ouvrir les transistors T1 et T2 simultanément en cas de détection d'une tension élevée correspondant à un court-circuit aux bornes de la bobine de protection 10. L'état de court-circuit de la bobine de commande 1A est produit sur une sortie A d'une des bascules BS qui peut être reliée au micro-contrôleur 4.

On notera que ce circuit de protection 11 des transistors de l'interrupteur statique selon l'invention, opère dans les toutes premières micro-secondes succédant au court-circuit, et de ce fait les transistors T1 et T2 s'ouvrent alors que le courant les traversant a une valeur faible, en général inférieure à leur courant nominal de l'ordre de 2,5A.

## Revendications

1. Un interrupteur statique de fin de course pour une commande de disjoncteur, **caractérisé en ce qu'**il comprend deux transistors (T1,T2) montés en série dans un circuit d'alimentation d'une bobine de commande (1A,1B) du disjoncteur, et commandés sélectivement pour fermer ou ouvrir ce circuit d'alimentation, un moyen de détection monté en dérivation aux bornes des premier et second transistors pour détecter un état de conduction ou de non conduction de l'un et de l'autre desdits premier et second transistors aux fins de réaliser un test de leur bon fonctionnement et, un troisième transistor (T3) monté en série avec le moyen de détection en vue de réaliser un test de bon fonctionnement du moyen de détection.

2. L'interrupteur selon la revendication 1 dans lequel le moyen de détection comprend un premier photocoupleur (D1) monté en dérivation aux bornes du premier transistor et un second photocoupleur (D2) monté en dérivation aux bornes du second transistor.

3. L'interrupteur selon la revendication 1, dans lequel le moyen de détection comprend une première source de courant (SC1) montée en série avec un photocoupleur (D1), la première source de courant et le photocoupleur étant montées en dérivation aux bornes du premier transistor, et une seconde source de courant (SC2) montée en dérivation aux bornes du second transistor.

4. L'interrupteur selon la revendication 3, dans lequel le second transistor (T2) est remplacé par deux thyristors (T2',T2") montés en parallèle.

5. Une commande de disjoncteur comprenant un interrupteur (2A',2B') selon l'une des revendications 1 à 4 et un système de protection de l'interrupteur contre une mise en court circuit de la bobine de commande (1A,1B), ce système de protection comprenant une bobine de protection (10) montée en série entre la bobine de commande et l'interrupteur, d'inductance bien plus faible que l'inductance de la bobine de commande, et un circuit (11) montée aux bornes de la bobine de protection apte à détecter que le niveau de tension aux bornes de cette bobine de protection est supérieur à un seuil correspondant à la mise en court-circuit de la bobine de commande et à forcer l'ouverture d'un transistor de l'interrupteur pour les mettre dans un état de non conduction afin d'ouvrir le circuit d'alimentation de la bobine de commande.

## Claims

1. A solid-state end of travel switch for use in a circuit-breaker control circuit, **characterized in that** it includes two transistors (T1, T2) connected in series in a power supply circuit of the control circuit (1A, 1B) of the circuit-breaker and selectively commanded to close or to open said power supply circuit, detector means shunting the first and second transistors to detect a conducting or non-conducting state of both of said first and second transistors in order to test that they are operating correctly, and a third transistor (T3) connected in series with the detector means to test correct operation of the detector means.

2. The switch according to claim 1, wherein the detector means comprise a first optocoupler (D1) shunting the first transistor and a second optocoupler (D2) shunting the second transistor.

3. The switch according to claim 1, wherein the detector means comprise a first current source (SC1) connected in series with an optocoupler (D1), the first current source and the optocoupler shunting the first transistor, and a second current source (SC2) shunting the second transistor.

4. The switch according to claim 3, wherein the second transistor (T2) is replaced by two thyristors (T2', T2") connected in parallel.

5. A circuit-breaker control circuit comprising a switch (2A', 2B') according to any one of claims 1 to 4 and a system for protecting the switch against short circuiting of the control coil (1A, 1B), said protection system comprising a protection coil (10) connected in series between the control coil and the switch and having a much lower inductance than the control coil, and a circuit (11) connected to the protection coil and adapted to detect that the voltage level at the terminals of the protection coil is greater than a threshold corresponding to the short circuiting of the control coil and to force opening of a transistor of the switch to turn them [sic] off in order to open the power supply circuit of the control coil.

## Patentansprüche

1. Statischer Endstellungsunterbrecher für eine Schaltautomatsteuerung, **dadurch gekennzeichnet, dass** er zwei Transistoren (T1, T2), die in einem Versorgungskreis einer Steuerspule (1A, 1B) des Schaltautomaten in Reihe geschaltet sind und wahlweise so gesteuert werden, dass sie diesen Versorgungskreis schließen oder öffnen, ein Erfassungsmittel, das parallel zu den Anschlüssen des ersten und des zweiten Transistors geschaltet ist, um einen leitenden oder nichtleitenden Zustand des einen und des anderen des ersten und des zweiten Transistors zu erfassen, um einen Test ihrer korrekten Funktion vorzunehmen, und einen dritten Transistor (T3), der mit dem Erfassungsmittel in Reihe geschaltet ist, um einen Test der korrekten Funktion des Erfassungsmittels vorzunehmen, umfasst.

2. Unterbrecher nach Anspruch 1, bei dem das Erfassungsmittel einen ersten Photokoppler (D1), der zu den Anschlüssen des ersten Transistors parallelgeschaltet ist, und einen zweiten Photokoppler (D2), der zu den Anschlüssen des zweiten Transistors parallelgeschaltet ist, umfasst.

3. Unterbrecher nach Anspruch 1, bei dem das Erfassungsmittel eine erste Stromquelle (SC1), die mit einem Photokoppler (D1) in Reihe geschaltet ist, wobei die erste Stromquelle und der Photokoppler zu den Anschlüssen des ersten Transistors parallelgeschaltet sind, und eine zweite Stromquelle (SC2), die zu den Anschlüssen des zweiten Transistors parallelgeschaltet ist, umfasst.

4. Unterbrecher nach Anspruch 3, bei dem der zweite Transistor (T2) durch zwei parallelgeschaltete Thyristoren (T2', T2") ersetzt ist.

5. Schaltautomatsteuerung, die einen Unterbrecher (2A', 2B') nach einem der Ansprüche I bis 4 sowie ein System für den Schutz des Unterbrechers vor einem Kurzschluss der Steuerspule (1A, 1B) umfasst, wobei dieses Schutzsystem eine Schutzspule (10), die zwischen der Steuerspule und dem Unterbrecher in Reihe geschaltet ist und eine viel geringere Induktivität als die Induktivität der Steuerspulen besitzt, sowie eine Schaltung (11), die an den Anschlüssen der Schutzspule angeordnet ist und erfassen kann, ob der Spannungspegel an den Anschlüssen dieser Schutzspule größer ist als ein Schwellenwert, der einem Kurzschluss der Steuerspule entspricht, und das Öffnen eines Transistors des Unterbrechers erzwingen kann, um sie in einen nichtleitenden Zustand zu versetzen, um den Versorgungskreis der Steuerspule zu öffnen, umfasst.
